# EUROPEAN PATENT SPECIFICATION

(11) **EP 1 096 675 B1**
(45) Date of publication and mention of the grant of the patent: **04.03.2009**
(21) Application number: 00123560.5
(22) Date of filing: 27.10.2000
(51) Int. Cl.: H03H 9/17

(54) **Piezoelectric resonator**
Piezoelektrischer Resonator
Résonateur piézoélectrique

(30) Priority: 29.10.1999 JP 30878599; 24.10.2000 JP 2000323782
(43) Date of publication of application: 02.05.2001
(73) Proprietor: MURATA MANUFACTURING CO., LTD., Nagaokakyo-shi, Kyoto 617-8555 (JP)
(72) Inventor: Ando, Akira, (A170) Intellectual Property Dept., Nagaokakyo-shi, Kyoto-fu 617-8555 (JP); Kimura, Masahiko, (A170) Intel. Property Dept., Nagaokakyo-shi, Kyoto-fu 617-8555 (JP); Sawada, Takuya, (A170) Intel. Property Dept., Nagaokakyo-shi, Kyoto-fu 617-8555 (JP); Inoue, Jiro, (A170) Intel. Property Dept., Nagaokakyo-shi, Kyoto-fu 617-8555 (JP); Kaida, Hiroaki, (A170) Intel. Property Dept., Nagaokakyo-shi, Kyoto-fu 617-8555 (JP); Nagae, Toru, (A170) Intel. Property Dept., Nagaokakyo-shi, Kyoto-fu 617-8555 (JP)
(74) Representative: Schoppe, Fritz

(56) References cited:
- DE-A1- 3 822 906
- JP-A- 5 243 898
- JP-A- 58 085 613
- ONO M ET AL: "THIRD-OVERTONE RESONATOR USING THICKNESS LONGITUDINAL MODE OF 36o Y-LINBO3" ELECTRONICS & COMMUNICATIONS IN JAPAN, PART II - ELECTRONICS, WILEY, HOBOKEN, NJ, US, vol. 82, no. 7, PART 2, July 1999 (1999-07), pages 50-58, XP000930122 ISSN: 8756-663X

## Description

### BACKGROUND OF THE INVENTION

### 1. Field of the Invention

The present invention relates to piezoelectric resonators, and in particular relates to a piezoelectric resonator for use principally in oscillators, etc.

### 2. Description of the Related Art

Hitherto, as a piezoelectric resonator for use principally in oscillators, an energy enclosing type resonator has been proposed and put to practical use, which is utilizing a longitudinal thickness mode fundamental wave of a piezoelectric single-chip, the third longitudinal thickness mode harmonic of a piezoelectric single-chip, a shear mode vibration of a piezoelectric single-chip, a longitudinal thickness mode harmonic of a monolithic piezoelectric body, and so forth.

However, in a conventional resonator utilizing a longitudinal thickness mode fundamental wave, materials capable of enclosing energy are limited, so that it is considerably difficult to manufacture an energy enclosing type resonator using a material having high thermal resistance. Although a conventional shear mode resonator can use a material having high thermal resistance, there has been a problem that the handling is complicated during producing resonators with high frequency due to a high speed of sound while improving the mechanical reliability of the element itself is difficult. Also, these resonators having a large electromechanical coefficient have another problem that they are hard to be used as resonators having a narrow tolerance.

Elements utilizing the third longitudinal thickness mode harmonic of a piezoelectric single-chip have not these problem; however, the optimum electrode diameter of the energy enclosing type resonator is large, the elements have a disadvantage in miniaturizing the element itself. Also, the element thickness is three times as large as that of the fundamental wave type, so that advances in the reduction in thickness are also difficult. The resonators utilizing a longitudinal thickness mode harmonic of a monolithic piezoelectric body can use material having high thermal resistance while the optimum electrode diameter of the energy enclosing type resonator is similar to that of the longitudinal thickness mode fundamental wave resonator, so that restrictions on the miniaturizing are small; however, there is a problem that they are hard to be used as resonators having a narrow tolerance because of a large electromechanical coefficient. As described above, by the conventional technique, compact oscillators having high thermal resistance and a narrow tolerance as well have been difficult to be achieved.

In addition, Japanese Unexamined Patent Application Publication No. 5-48377 invented by the inventors discloses a piezoelectric resonator using a deposited material formed of two layers of a paraelectric layer without piezoelectricity and a piezoelectric layer. In this piezoelectric resonator, there have been problems that since an electric field is applied in the state that the piezoelectric layer and the paraelectric layer are connected in series, the piezoelectric layer cannot be effectively vibrated, and characteristics as a resonator are largely changed because a capacitive component is inserted in series in an equivalent circuit.

### SUMMARY OF THE INVENTION

Accordingly, it is a principal object of the present invention to provide a piezoelectric resonator capable of achieving a compact oscillator with high performance having high thermal resistance and a narrow tolerance.

According to the present invention, there is provided a piezoelectric resonator as defined in claim 1. Such a resonator comprises: at least one pair of vibration electrodes; and an element body comprising at least one excitation layer sandwiched between the at least one pair of vibration electrodes and excited by an electric field so as to be vibrated, and at least one non-excitation layer not exited so as to be vibrated, the piezoelectric resonator exciting a longitudinal thickness mode harmonic of the n-th order (n is an integer other than 1), wherein when the thickness of the element body is denoted by t and a unit layer thickness is represented by approximately t/n, the thickness of the excitation layer is to be an integer multiple of the unit layer thickness and the thickness of the at least one non-excitation layer is to be an integer multiple of the unit layer thickness.

In such a piezoelectric resonator, it is preferable that the unit layer thickness of the excitation layer be in the 0.7 t/n to 1.2 t/n range and the unit layer thickness of the non-excitation layer be in the range of 0.8 t/n to 1.3 t/n.

Also, the vibration electrodes may be formed only on one principal plane of the non-excitation layer or the vibration electrodes being at the same potential may be formed on both principal planes of the non-excitation layer.

Furthermore, the non-excitation layer may be made of non-polarized piezoelectric ceramics or dielectric ceramics.

Such a piezoelectric resonator may further comprise: a first and a second end-face electrode formed on the surface of the element body; a spurious response suppressing electrode electrically connected to the first end-face electrode, wherein the spurious response suppressing electrode is formed so as to have a constant gap to one end of the vibrating electrode connected to the second end-face at the other end in a direction orthogonal to the depositing direction of the excitation layer and the non-excitation layer.

Preferably, a ratio between the gap and the unit layer thickness, i.e., gap/unit layer thickness, is in the range of 1.0 to 3.0.

By applying an electric field between vibration electrodes formed by sandwiching the excitation layer, the excitation layer is excited to be vibrated in a longitudinal thickness mode. At this time, since the electric field is not applied to the non-excitation layer or the non-excitation layer is made of a material which cannot be excited even when an electric field is applied thereto, the non-excitation layer cannot be excited to be vibrated; however, a standing wave is also transmitted to the non-excitation layer by the vibration of the excitation layer, so that the entirety becomes a piezoelectric resonator utilizing a longitudinal thickness mode harmonic of a higher order. That is, when the thickness of the element body is denoted by t and a unit layer thickness is represented by approximately t/n, by multiplying the thickness of an excitation layer and at least one of non-excitation layers by an integer multiple of the unit layer thickness t/n, a piezoelectric resonator utilizing a longitudinal thickness mode harmonic of the n-th order as the entirety can be obtained.

Such a piezoelectric resonator can use a material having high thermal resistance and can reduce the value of an electromechanical coefficient as well, so that it is to be a resonator having a narrow tolerance.

In such a piezoelectric resonator, when the unit layer thickness of the excitation layer is in the 0.7 t/n to 1.2 t/n range and the unit layer thickness of the non-excitation layer is in the range of 0.8 t/n to 1.3 t/n, a piezoelectric resonator with excellent characteristics can be obtained.

A non-excitation layer can be formed so that an electric field cannot be applied thereto by forming it not to be sandwiched by vibration electrodes.

Also, a non-excitation layer cannot be excited even when an electric field is applied thereto by using non-polarized piezoelectric ceramics or dielectric ceramics. In this case, of course, the electrodes may be arranged so that an electric field cannot be applied to the non-excitation layer.

Furthermore, by forming a spurious response suppressing electrode, vibrations in any mode other than a desired mode can be suppressed.

These effects will be remarkable when a ratio gap/unit layer thickness is in the range of 1.0 to 3.0.

These and other objects, features, and advantages of the present invention will become more apparent from the following detailed description of embodiments according to the present invention taken in connection with the drawings.

### BRIEF DESCRIPTION OF THE DRAWINGS

Fig. 1 is a schematic representation showing an example of a piezoelectric resonator according to the present invention;
Fig. 2 is a schematic representation showing another example of a piezoelectric resonator according to the present invention;
Fig. 3 is a schematic representation showing another example of a piezoelectric resonator not falling within the scope of the invention as claimed;
Fig. 4 is a schematic representation showing another example of a piezoelectric resonator according to the present invention;
Fig. 5 is a schematic representation showing another example of a piezoelectric resonator according to the present invention;
Fig. 6 is a schematic representation showing a state that thicknesses of an excitation layer and a non-excitation layer are changed in the piezoelectric resonator according to the present invention;
Fig. 7 is a schematic representation showing an example of a piezoelectric resonator having a spurious response suppressing electrode formed therein;
Fig. 8 is a schematic representation showing another example of a piezoelectric resonator having a spurious response suppressing electrode formed therein;
Fig. 9 is a schematic representation showing another example of a piezoelectric resonator having spurious response suppressing electrodes formed therein;
Fig. 10 is a schematic representation showing part of a process for manufacturing the piezoelectric resonator shown in Fig. 1;
Fig. 11 is a schematic representation for showing a sintered body produced in the process shown in Fig. 10;
Fig. 12 is a schematic representation for showing an example of a conventional piezoelectric resonator as a comparative sample;
Fig. 13 is a graph showing frequency characteristics of the impedance of the piezoelectric resonator according to the present invention shown in Fig. 1 and the conventional piezoelectric resonator shown in Fig. 12;
Fig. 14 is a schematic representation for showing a conventional piezoelectric resonator used as a comparative example with the piezoelectric resonator shown in Fig. 2;
Fig. 15 is a graph showing frequency characteristics of the impedance of the piezoelectric resonator according to the present invention shown in Fig. 2 and the conventional piezoelectric resonator shown in Fig. 14;
Fig. 16 is a graph for showing the relationship between the thickness of the non-excitation layer and the value θₘₐₓ of the piezoelectric resonator shown in Fig. 6;
Fig. 17 is a graph showing the relationship between the value E_{sd}/D and the value θₘₐₓ about a fundamental wave, the second harmonic, and the third harmonic excited in the piezoelectric resonator shown in Fig. 7;
Fig. 18 is a graph showing the relationship between the value dF/Fa and the value E_{sd}/D of the piezoelectric resonator shown in Fig. 7; and
Fig. 19 is a schematic representation showing an example in which the shape of a vibration electrode is changed in the piezoelectric resonator according to the present invention.

### DESCRIPTION OF THE PREFERRED EMBODIMENTS

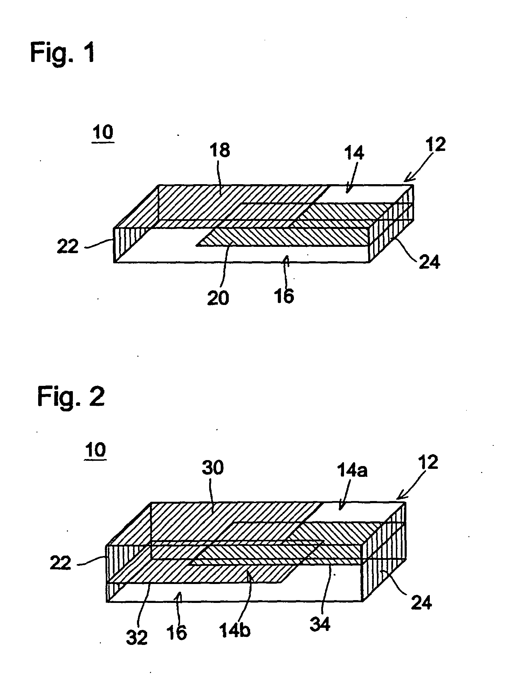

Fig. 1 is a schematic representation showing an example of a piezoelectric resonator according to the present invention. A piezoelectric resonator 10 comprises an element body 12 comprising an excitation layer 14 and a non-excitation layer 16. The non-excitation layer 16 indicates a layer not excited to be vibrated as will be described when an electric field is applied to the piezoelectric resonator 10. The excitation layer 14 is polarized in the thickness direction at this time. The element body 12 is formed so that the excitation layer 14 and the non-excitation layer 16 have the same thickness. That is, when the thickness of the element body 12 is denoted by t, the respective thicknesses of the excitation layer 14 and the non-excitation layer 16 are t/2.

On both surfaces of the excitation layer 14, vibration electrodes 18 and 20 are formed. The vibration electrode 18 is formed on the top surface of the excitation layer 14 while the vibration electrode 20 is formed between the excitation layer 14 and the non-excitation layer 16. The one vibration electrode 18 is formed from one end of the excitation layer 14 toward the central portion thereof while the other vibration electrode 20 is formed from the other end of the excitation layer 14 toward the central portion thereof. At the central portion of the excitation layer 14, the two vibration electrodes 18 and 20 oppose each other. On both end-faces of the element body 12, end-face electrodes 22 and 24 are further formed. The one end-face electrode 22 is connected to the vibration electrode 18 on the top surface of the excitation layer 14 while the other end-face electrode 24 is connected to the vibration electrode 20 between the excitation layer 14 and the non-excitation layer 16.

In the piezoelectric resonator 10, by applying a signal to the end-face electrodes 22 and 24, an electric field is applied between the vibration electrodes 18 and 20 in the thickness direction of the excitation layer 14. Thereby, the excitation layer 14 is excited to be vibrated in a longitudinal thickness mode. At this time, an electric field is not applied to the non-excitation layer 16, so that the non-excitation layer 16 is not excited to be vibrated. However, since the excitation layer 14 is excited to be vibrated in a longitudinal thickness mode, a standing wave is thereby transmitted also to the non-excitation layer 16, so that the entirety becomes a piezoelectric resonator utilizing a longitudinal thickness mode harmonic of a higher order. The piezoelectric resonator 10 shown in Fig. 1 is formed by depositing the excitation layer 14 and the non-excitation layer 16, having the same thickness, so that it is a piezoelectric resonator utilizing the second longitudinal thickness mode harmonic. In the piezoelectric resonator 10 of such a structure, the vibration electrodes 18 and 20 oppose each other only in the central portion of the excitation layer 14, and an energy enclosing region is thereby formed therein so as to form an energy enclosing type piezoelectric resonator.

The piezoelectric resonator 10 can use a material having high thermal resistance as a material of the excitation layer 14 and can reduce the value of an electromechanical coefficient as well, so that it is to be a resonator having a narrow tolerance. Furthermore, by forming the vibration electrodes 18 and 20 on both surfaces of the excitation layer 14, an electric field can be applied only to the excitation layer 14, so that the piezoelectric resonator 10 can be efficiently excited to be vibrated in a longitudinal thickness mode. Also, in an equivalent circuit, a capacitive component is not inserted in series to the excitation layer 14, thereby obtaining stable characteristics of the resonator.

As shown in Fig. 2, the piezoelectric resonator 10 may also be a piezoelectric resonator 10 utilizing the third longitudinal thickness mode harmonic by using a piezoelectric resonator including an element body 12 formed by depositing two excitation layers 14a and 14b, and the one non-excitation layer 16. In the piezoelectric resonator 10, on both sides of the excitation layers 14a and 14b, vibration electrodes 30 and 32 are formed so as to be connected to the end-face electrode 22. Between the two excitation layers 14a and 14b, another vibration electrode 34 is formed so as to be connected to the end-face electrode 24. In addition, on the external surface of the non-excitation layer 16, a vibration electrode is not formed, so that the non-excitation layer 16 is formed to be not applied by an electric field. When the thickness of the element body 12 is denoted by t, the thicknesses of the excitation layers 14a and 14b, and the non-excitation layer 16 are respectively t/3.

In such a piezoelectric resonator 10, an electric field is applied to the excitation layers 14a and 14b, which in turn are excited to be vibrated in a longitudinal thickness mode. At this time, a standing wave is also transmitted to the non-excitation layer 16, so that the entirety becomes a piezoelectric resonator utilizing the third longitudinal thickness mode harmonic.

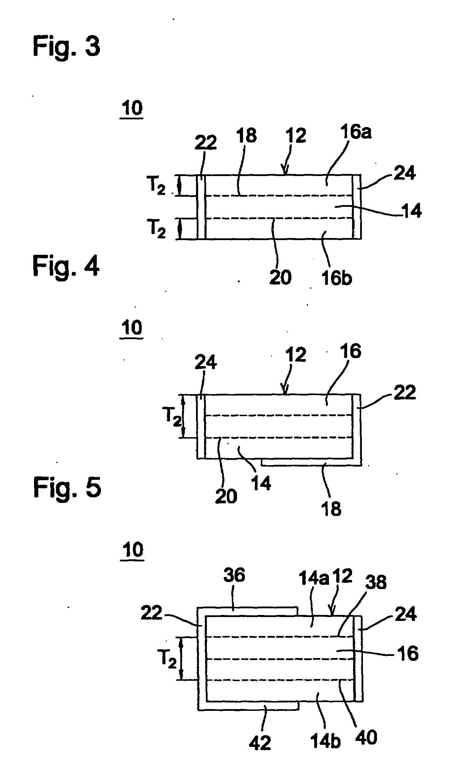

Furthermore, as shown in Fig. 3, an element body 12 formed of an excitation layer 14 having non-excitation layers 16a and 16b respectively formed on both sides thereof may be used. In this case, when the thickness of the element body 12 is denoted by t, the excitation layer 14 is formed to have the thicknesses of t/3, and the thickness T₂ of each of the two non-excitation layers 16a and 16b is to have the thickness of t/3. On both sides of the excitation layer 14 in the center, the vibration electrodes 18 and 20 are formed so as to be respectively connected to the end-face electrodes 22 and 24. Also, in such a piezoelectric resonator 10, an electric field is applied to the excitation layer 14, which in turn are excited to be vibrated in a longitudinal thickness mode, and a standing wave is transmitted to the non-excitation layers 16a and 16b formed on the both sides of the excitation layer 14, so that the entirety becomes a piezoelectric resonator utilizing the third longitudinal thickness mode harmonic.

Furthermore, as shown in Fig. 4, in the piezoelectric resonator 10 using the element body 12 formed by depositing the excitation layer 14 and the non-excitation layer 16, when the thickness of the element body 12 is denoted by t, the thickness of the excitation layer 14 may be t/3 and the thickness T₂ of the non-excitation layer 16 may be 2 t/3. In this case, when the excitation layer 14 is excited to be vibrated in a longitudinal thickness mode, a standing wave is transmitted to the non-excitation layer having twice the thickness of the excitation layer 14, so that the entirety becomes a piezoelectric resonator utilizing the third longitudinal thickness mode harmonic.

Also, as shown in Fig. 5, the piezoelectric resonator 10 may use an element body 12, in the center of which formed is the non-excitation 16 having excitation layers 14a and 14b formed on both sides thereof. In this piezoelectric resonator 10, when the thickness of the element body 12 is denoted by t, the excitation layers 14a and 14b are formed to have the respective thicknesses of t/4 and the thickness T₂ of the non-excitation layer 16 is formed to have the thickness of t/2. On both sides of the excitation layer 14a, vibrating electrodes 36 and 38 are formed while on both sides of the excitation layer 14b, vibrating electrodes 40 and 42 are formed. The vibrating electrodes 36 and 42 formed on the external surfaces of the element body 12 are connected to the end-face electrode 22 while the vibrating electrodes 38 and 40 formed on the internal portions of the element body 12 are connected to the end-face electrode 24.

In such a piezoelectric resonator 10, an electric field is applied to the excitation layers 14a and 14b on both sides of the element body 12, which in turn are excited to be vibrated in a longitudinal thickness mode. However, since the vibrating electrodes 38 and 40 on both sides of the central non-excitation layer 16 are connected to the same end-face electrode 24, an electric field is not applied to the non-excitation layer 16 so as not to be excited to be vibrated. A standing wave is transmitted to the central non-excitation layer 16 having twice the thickness of each of the excitation layers 14a and 14b, so that the entirety becomes a piezoelectric resonator utilizing the fourth longitudinal thickness mode harmonic.

As described above, when the thickness of the element body 12 is denoted by t and a unit layer thickness is represented by t/n, by multiplying the thickness of an excitation layer and a non-excitation layer by an integer multiple of t/n, a piezoelectric resonator utilizing a longitudinal thickness mode harmonic of the n-th order as the entirety can be obtained. In addition, in the each above-mentioned piezoelectric resonator 10, a non-excitation layer is formed by having a structure in that an electric field is not applied; however, although in a structure in that an electric field is applied, a non-excitation layer can be obtained by forming it by non-polarized piezoelectric ceramics or dielectric ceramics.

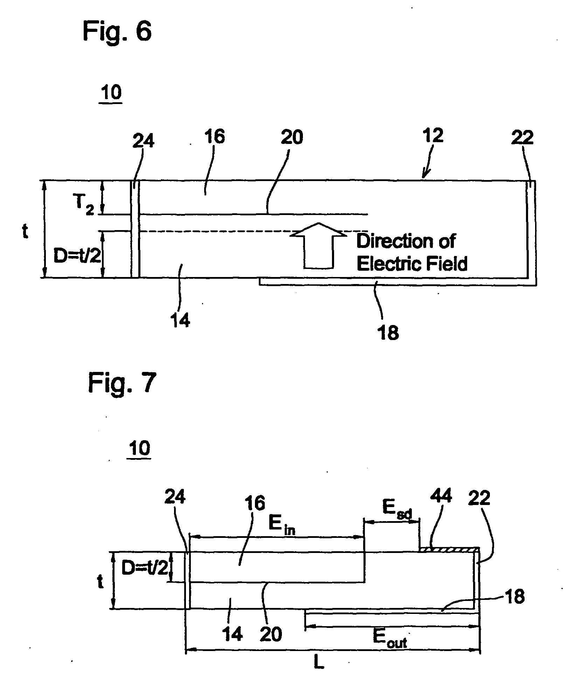

In addition, when the thickness of the element body 12 is denoted by t, thicknesses of the excitation layer and the non-excitation layer are not necessarily to be precisely t/n. For example, as shown in Fig. 6, in the piezoelectric resonator 10 utilizing the second longitudinal thickness mode harmonic, the thickness of the excitation layer 14 may be larger than the thickness T₂ of the non-excitation layer 16. Conversely, the thickness of the excitation layer 14 may be smaller than the thickness T₂ of the non-excitation layer 16. From an experimental result, it is understood that a piezoelectric resonator having excellent characteristics can be obtained when the excitation layer 14 has the thickness in the 0.7 t/n-1 to 1.2 t/n range and the non-excitation layer 16 has the thickness in the 0.8 t/n-1 to 1.3 t/n range, if the thickness of the element body 12 is denoted by t.

Furthermore, as shown in Fig. 7, by forming a spurious response suppressing electrode, a spurious output can be suppressed. In the piezoelectric resonator 10, a spurious response suppressing electrode 44 is formed on the external surface of the non-excitation layer 16 so as to be connected to the end-face electrode 22. The spurious response suppressing electrode 44 is formed in a direction orthogonal to the depositing direction of the excitation layer 14 and the non-excitation layer 16 and spaced from the internal vibration electrode 20 connected to the end-face electrode 24. In such a manner, by forming the spurious response suppressing electrode 44, a spurious output can be suppressed. According to an experimental result, it is understood that such an effect is noticeable when the value of E_{sd}/D is in the 1.0 to 3.0 range, wherein E_{sd} represents a gap between the vibration electrode 20 and the spurious response suppressing electrode 44, and D is a unit layer thickness indicating 1/2 of the thickness t of the element body 12.

As the piezoelectric resonator 10 shown in Fig. 7 is a piezoelectric resonator utilizing the second longitudinal thickness mode harmonic, D is 1/2 of the thickness t of the element body 12. In general, when the piezoelectric resonator is a piezoelectric resonator utilizing a longitudinal thickness mode harmonic of the n-th order, when the thickness of the element body 12 is denoted by t, D is a unit layer thickness indicated by t/D. When a ratio between the gap E_{sd} and the unit layer thickness D is in the range of 1.0 to 3.0, the spurious suppressing effect becomes noticeable.

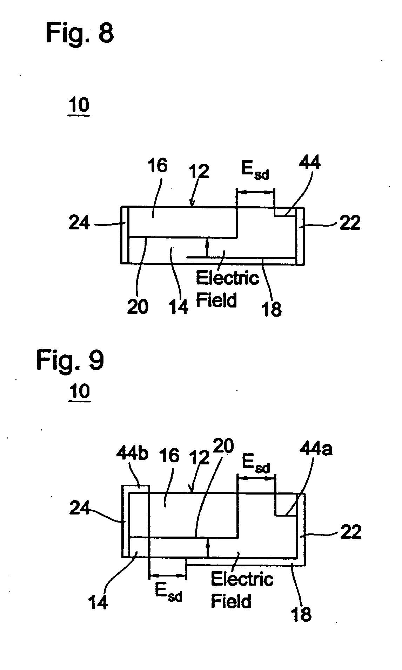

As a piezoelectric resonator 10 utilizing the second longitudinal thickness mode harmonic having the spurious response suppressing electrode 44 formed therein, as shown in Fig. 8, may also be the one in that the vibration electrodes 18 and 20, and the spurious response suppressing electrode 44 are not exposed outside the surface of the element body 12. Also, as shown in Fig. 9, a spurious response suppressing electrode may be formed on a piezoelectric resonator utilizing the third longitudinal thickness mode harmonic with the non-excitation layer 16 having twice the thickness of the excitation layer 14. In the piezoelectric resonator 10 shown in Fig. 9, a spurious response suppressing electrode 44a is formed in an intermediate portion of the thickness direction of the non-excitation layer 16 and another spurious response suppressing electrode 44b is formed on the surface of the non-excitation layer 16. A gap E_{sd} is formed between the spurious response suppressing electrode 44a and the internal vibration electrode 20 while a gap E_{sd} is formed between the spurious response suppressing electrode 44b and the external vibration electrode 18. In such a manner, by forming a spurious response suppressing electrode 44, a spurious output can be suppressed not only in a piezoelectric resonator utilizing the second longitudinal thickness mode harmonic but also in a piezoelectric resonator utilizing a longitudinal thickness mode harmonic of the n-th order.

### Examples

### (Example 1)

First, lead oxide, titanium dioxide, lanthan oxide, and manganese carbonate were prepared so that a molar ratio between Pb : La : Ti : Mn is to be 0.865 : 0.090 : 1.000 : 0.020; they were stirred to be mixed for about ten hours in a ball mill together with water and a grinding media of partially stabilized zirconia; after dehydration, the mixture was calcined in the atmosphere at a temperature of 800 to 1000°C for about two hours. Slurry for forming sheets was produced by mixing a vinyl acetate binder into the obtained calcined material in a ratio that 10g of the reduced solid of the binder, 30g of water, and a proper quantity of a plasticizer were added to 100g of the calcined material.

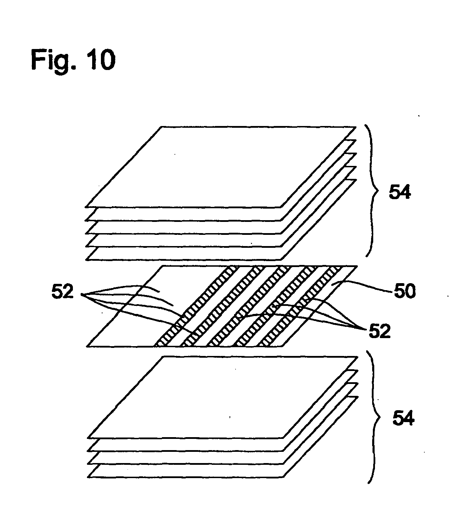

A sheet having a thickness of approximate 50 µm was formed by a doctor blade method from the slurry; the formed sheet was cut into a size of 20 mm × 30 mm; as shown in Fig. 10, an electrode pattern 52 was screen-printed on a part of a sheet 50 in a parallel lines pattern; the used screen mesh was of #400; an electrode material was platinum; a paste for printing was the mixture of platinum and an varnish, including 50 to 70wt% of platinum; as shown in Fig. 10, sheets 54 having no electrode pattern formed thereon were laid up on both surfaces of a sheet 50 having an electrode pattern 52 formed thereon so as to be pressed under a pressure of 100 to 200 MPa; and the obtained pressed product was burned at 1200°C for about two hours so as to obtain a sintered body 58 having an electrode 56 internally formed therein.

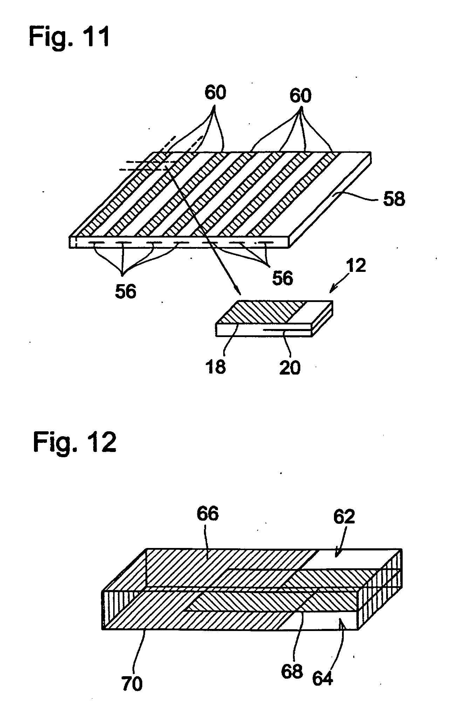

On the entire both surfaces of the obtained sintered body 58, silver electrodes were formed by vapor deposition; then the sintered body 58 was polarized in oil at a temperature of 100 to 150°C by applying an electric field of 5 to 10 MV/m; then after holding the sample in air at a temperature of 100 to 250°C for one hour, the vapor-deposited silver electrodes were patterned by etching; the patterned silver electrodes 60, as shown in Fig. 11, were formed so as to be parallel to each other and to oppose partially to the electrode 56 formed inside the sintered body; as shown by the dotted lines in Fig. 11, the sintered body was cut so that the electrodes 56 formed inside the sintered body and the electrodes 60 formed on the surface of the sintered body 58 were exposed on opposing end-faces so as to obtain the element body 12 having electrodes 18 and 20 formed thereon; on the side faces of the element body 12, end-face electrodes 22 and 24 were formed so as to be connected to the electrodes 18 and 20 exposed on the opposing end-faces; in such a manner, the piezoelectric resonator shown in Fig. 1 was produced.

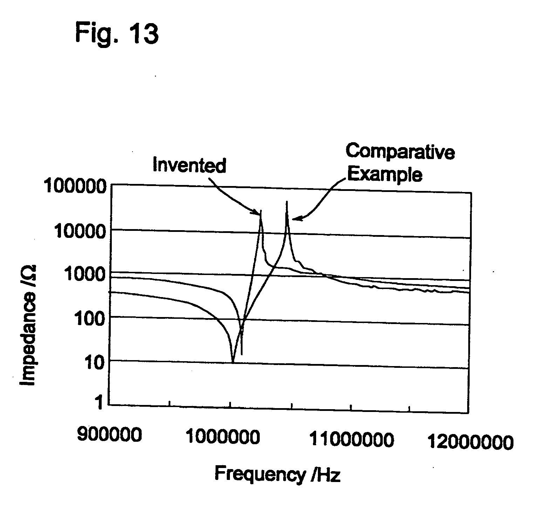

As to the obtained piezoelectric resonator 10, frequency characteristics of impedance were measured. As a comparative example, about a conventional piezoelectric resonator having electrodes 66, 68, and 70 formed thereon and respectively opposing two excitation layers 62 and 64 as shown in Fig. 12, frequency characteristics of the impedance were measured. The obtained result is shown in Fig. 13. It is understood from Fig. 13 that in the piezoelectric resonator 10 according to the present invention, resonance characteristics with a narrower bandwidth compared with that of the conventional piezoelectric resonator were obtained. In addition, the piezoelectric resonator 10 according to the embodiment excites the second longitudinal thickness mode harmonic.

### (Example 2)

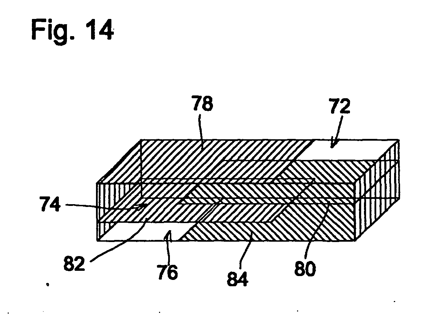

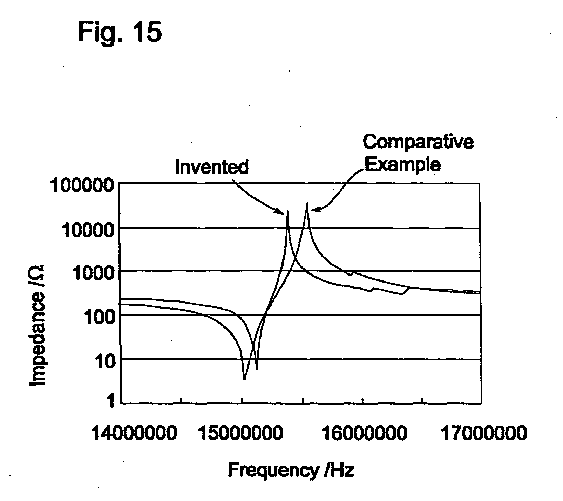

As shown in Fig. 2, a piezoelectric resonator 10 was produced, which comprises two excitation layers and one non-excitation layer, and excites the third longitudinal thickness mode harmonic. As to the obtained piezoelectric resonator 10, frequency characteristics of the impedance were measured. As a comparative example, about a conventional piezoelectric resonator having electrodes 78, 80, 82, and 84 formed thereon and respectively opposing three excitation layers 72, 74, and 76 as shown in Fig. 14, frequency characteristics of the impedance were measured. The obtained result is shown in Fig. 15. It is understood from Fig. 15 that in the piezoelectric resonator 10 according to the present invention, resonance characteristics with a narrower bandwidth compared with that of the conventional piezoelectric resonator were obtained.

### (Example 3)

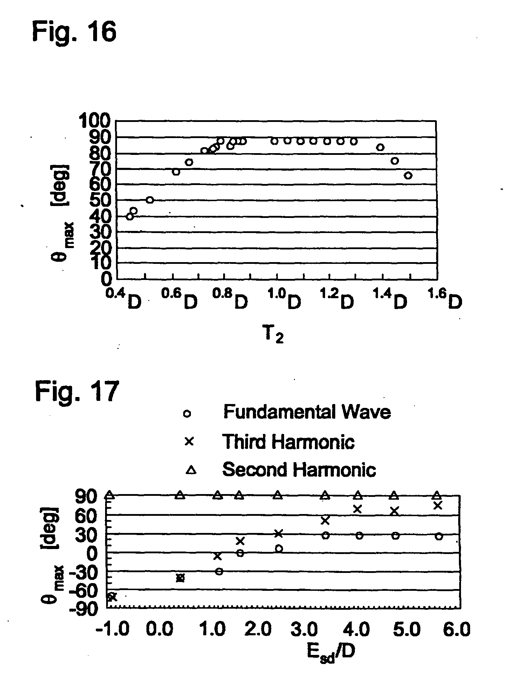

As shown in Fig. 6, a piezoelectric resonator 10 utilizing the second longitudinal thickness mode harmonic was formed by changing thicknesses of the excitation layer 14 and the non-excitation layer 16. Then the relationship between the thickness T₂ of the non-excitation layer 16 and the maximum value θₘₐₓ of phase characteristics of the piezoelectric resonator 10 was measured, and the result thereof is shown in Fig. 16. As understood from Fig. 16, if the thickness of the element body 12 is denoted by t, and D = t/2, the value of θₘₐₓ is large indicating excellent characteristics when T₂ is in the 0.8D to 1.3D range, that is the thickness of the excitation layer 14 is in the 0.7D to 1.2D.

### (Example 4)

As shown in Fig. 7, a piezoelectric resonator 10 comprising the spurious response suppressing electrode 44 and utilizing the second longitudinal thickness mode harmonic was formed. In addition, in the piezoelectric resonator 10 shown in Fig. 7, the thickness of the element body 12 was t = 0.245 mm, the length of the element body 12 was L = 2.2 mm, and the lengths of the vibration electrodes 18 and 20 were: Ein = 1.35 mm, Eout = 1.35 mm, respectively. Then the relationship between a ratio E_{sd}/D of the gap E_{sd} and the unit layer thickness D and the value θₘₐₓ was measured, and the result thereof is shown in Fig. 17. In Fig. 17, values θₘₐₓ of the second harmonic excited by the piezoelectric resonator 10, a fundamental wave which is a spurious signal, and the third harmonic are shown. As understood from Fig. 17, when the value E_{sd}/D is equal to or less than 3.0, the values θₘₐₓ of the fundamental wave which is the spurious signal and the third harmonic are small, the value θₘₐₓ of the second harmonic is large.

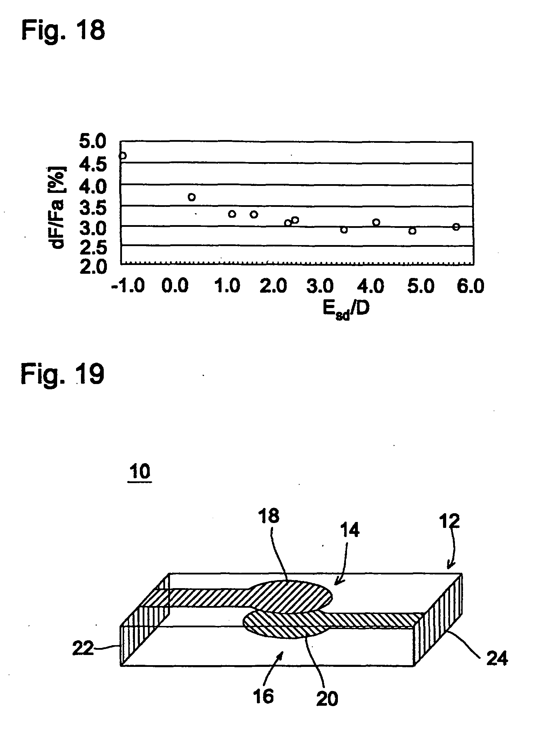

Furthermore, in the piezoelectric resonator 10 shown in Fig. 7, the relationship between the relative bandwidth dF/Fa and E_{sd}/D was measured, and the result thereof is shown in Fig. 18. As understood from Fig. 18, when E_{sd}/D is equal to or more than 1.0, a narrow bandwidth region was obtained. In such a piezoelectric resonator 10, a narrow bandwidth region is desired, so that it is preferable that E_{sd}/D be equal to or more than 1.0. Accordingly, from Figs. 17 and 18, it is preferable that E_{sd}/D be in the 1.0 to 3.0 range.

As described above, the piezoelectric resonator 10 according to the present invention may excite any order of a longitudinal thickness mode harmonic. As a shape of the vibration electrodes 18 and 20 for forming an energy-enclosing region, it may be circular as shown in Fig. 19, oval, or a shape connecting any of these shapes to a rectangular shape.

As a material of the excitation layer 14, as long as it is piezoelectric body, any materials may be used; it is confirmed by the inventor that even when a Poisson's ratio is equal to or more than 1/3, or less than 1/3, energy enclosing can be achieved. As a material of the excitation layer of a unitarily sintering structure, ceramic materials are generally used. As these materials, lead titanate, lead titanate zirconate, barium titanate, tungsten bronze, pyrochlore, and a layer compound such as a bismuth layer compound in particular may be applicable. The similar effect may be achieved by integration of a single crystal piezoelectric material with an arbitrary non-excitation layer by using a joining or an adhesion technique, etc.

Also, the materials of the excitation layer 14 and the non-excitation layer 16 may be the same or different. When they are the same, since there is no difference in a thermal expansion rate, so that any internal stress cannot be generated even when the temperature is changed, resulting in the high reliability of the piezoelectric resonator. When they are different, the correction of temperature characteristics of the resonance frequency and the control of the Q value of the resonator can be enabled. In such a manner, by properly selecting materials of the excitation layer 14 and the non-excitation layer 16, various characteristics can be achieved. Furthermore, the non-excitation layer 16 may have or may not have piezoelectricity as long as it is not excited to be vibrated by the electric field applied to the piezoelectric resonator 10.

According to the present invention, a piezoelectric resonator capable of achieving a compact oscillator with high performance having high thermal resistance and a narrow tolerance can be obtained.

In such a piezoelectric resonator, by forming a spurious response suppressing electrode, a piezoelectric resonator with a small spurious response can be obtained.

## Claims

1. A piezoelectric resonator (10) comprising:
at least one pair of vibration electrodes (18, 20; 38, 40); and
an element body (12) comprising at least one excitation layer (14; 14a, 14b) sandwiched between the at least one pair of vibration electrodes (18, 20; 38, 40) and excited by an electric field so as to be vibrated, and at least one non-excitation layer (16; 16a, 16b) not exited so as to be vibrated, the piezoelectric resonator (10) exciting a longitudinal thickness mode harmonic of the n-th order (n is an integer other than 1),
wherein when the thickness of the element body (12) is denoted by t and a unit layer thickness is represented by approximately t/n, the thickness of the excitation layer (14; 14a, 14b) is to be an integer multiple of the unit layer thickness and the thickness of the at least one non-excitation layer (16; 16a, 16b) is to be an integer multiple of the unit layer thickness,
wherein said at least one excitation layer (14; 14a; 14b) is formed adjacent one outer principal plane of said element body (12) without a non-excitation layer between the excitation layer and the outer principal plane.

2. A piezoelectric resonator (10) according to Claim 1, wherein the unit layer thickness of the excitation layer (14; 14a, 14b) is in the 0.7 t/n to 1.2 t/n range and the unit layer thickness of the non-excitation layer (16; 16a, 16b) is in the range of 0.8 t/n to 1.3 t/n.

3. A piezoelectric resonator (10) according to any one of Claims 1 and 2, wherein the vibration electrodes (18, 20) are formed only on one principal plane of the non-excitation layer (16) or the vibration electrodes (38, 40) being at the same potential are formed on both principal planes of the non-excitation layer (16).

4. A piezoelectric resonator according to any one of Claims 1 to 3, wherein the non-excitation layer (16; 16a, 16b) is made of non-polarized piezoelectric ceramics or dielectric ceramics.

5. A piezoelectric resonator (10) according to any one of Claims 1 to 4, further comprising:
a first and a second end-face electrode (22, 24) formed on the surface of the element body (12);
a spurious response suppressing electrode (44; 44a) electrically connected to the first end-face electrode (22),
wherein the spurious response suppressing electrode (44) is formed so as to have a constant gap (ESD) to one end of the vibrating electrode (20) connected to the second end-face at the other end in a direction orthogonal to the depositing direction of the excitation layer (14) and the non-excitation layer (16).

6. A piezoelectric resonator (10) according to Claim 5, wherein a ratio between the gap (ESD) and the unit layer thickness (D), i.e., gap/unit layer thickness, is in the range of 1.0 to 3.0.

7. A piezoelectric resonator (10) according to one of claims 1 to 6 comprising two excitation layers (14a, 14b) formed adjacent both opposite outer principal planes of said element body (12) without a non-excitation layer between the respective excitation layer and the outer principal plane.

## Patentansprüche

1. Ein piezoelektrischer Resonator (10), der folgende Merkmale aufweist:
zumindest ein Paar aus Vibrationselektroden (18, 20; 38, 40); und
einen Elementkörper (12), der zumindest eine Erregungsschicht (14; 14a, 14b), die sandwichartig zwischen dem zumindest einen Paar aus Vibrationselektroden (18, 20; 38, 40) angeordnet ist und durch ein elektrisches Feld erregt wird, um in Schwingung versetzt zu werden, und zumindest eine Nichterregungsschicht (16; 16a, 16b) aufweist, die nicht erregt wird, um in Schwingung versetzt zu werden, wobei der piezoelektrische Resonator (10) eine Längs-Dicken-Moden-Harmonische der n-ten Ordnung erregt (n ist eine ganze Zahl ungleich 1),
wobei, wenn die Dicke des Elementkörpers (12) durch t bezeichnet ist und eine Einheitsschichtdicke durch ungefähr t/n dargestellt ist, soll die Dicke der Erregungsschicht (14; 14a, 14b) ein ganzzahliges Mehrfaches der Einheitsschichtdicke sein und die Dicke der zumindest einen Nichterregungsschicht (16; 16a, 16b) soll ein ganzzahliges Mehrfaches der Einheitsschichtdicke sein,
wobei die zumindest eine Erregungsschicht (14; 14a, 14b) benachbart zu einer äußeren Hauptebene des Elementkörpers (12) gebildet ist, ohne eine Nichterregungsschicht zwischen der Erregungsschicht und der äußeren Hauptebene.

2. Ein piezoelektrischer Resonator (10) gemäß Anspruch 1, bei dem die Einheitsschichtdicke der Erregungsschicht (14; 14a, 14b) im Bereich von 0,7 t/n bis 1,2 t/n ist und die Einheitsschichtdicke der Nichterregungsschicht (16; 16a, 16b) im Bereich von 0,8 t/n bis 1,3 t/n ist.

3. Ein piezoelektrischer Resonator (10) gemäß einem der Ansprüche 1 und 2, bei dem die Vibrationselektroden (18, 20) nur auf einer Hauptebene der Nichterregungsschicht (16) gebildet sind oder die Vibrationselektroden (38, 40), die auf demselben Potential sind, auf beiden Hauptebenen der Nichterregungsschicht (16) gebildet sind.

4. Ein piezoelektrischer Resonator gemäß einem der Ansprüche 1 bis 3, bei dem die Nichterregungsschicht (16; 16a, 16b) aus einer nichtpolarisierten piezoelektrischen Keramik oder dielektrischen Keramik hergestellt ist.

5. Ein piezoelektrischer Resonator (10) gemäß einem der Ansprüche 1 bis 4, der ferner folgende Merkmale aufweist:
eine erste und eine zweite Endflächenelektrode (22, 24), die auf der Oberfläche des Elementkörpers (12) gebildet sind;
eine Elektrode (44; 44a) zum Unterdrücken eines unerwünschten Verhaltens, die elektrisch mit der ersten Endflächenelektrode (22) verbunden ist;
wobei die Elektrode (44) zum Unterdrücken eines unerwünschten Verhaltens gebildet ist, um einen konstanten Zwischenraum (ESD) zu einem Ende der Vibrationselektrode (20) zu haben, die mit der zweiten Endfläche an dem anderen Ende verbunden ist, in einer Richtung orthogonal zu der Aufbringungsrichtung der Erregungsschicht (14) und der Nichterregungsschicht (16).

6. Ein piezoelektrischer Resonator (10) gemäß Anspruch 5, bei dem ein Verhältnis zwischen dem Zwischenraum (ESD) und der Einheitsschichtdicke (D), d. h. Zwischenraum/Einheitsschichtdicke, im Bereich von 1,0 bis 3,0 ist.

7. Ein piezoelektrischer Resonator (10) gemäß einem der Ansprüche 1 bis 6, der zwei Erregungsschichten (14a, 14b) aufweist, die benachbart zu beiden gegenüberliegenden äußeren Hauptebenen des Elementkörpers (12) gebildet sind, ohne eine Nichterregungsschicht zwischen der entsprechenden Erregungsschicht und der äußeren Hauptebene.

## Revendications

1. Résonateur piézoélectrique (10) comprenant :
au moins une paire d'électrodes (18, 20 ; 38, 40) de vibration ; et
un corps (12) d'élément comprenant au moins une couche (14 ; 14a, 14b) d'excitation prise en sandwich entre l'au moins une paire d'électrodes (18, 20 ; 38, 40) de vibration et excitée par un champ électrique de façon à être mise en vibration, et au moins une couche (16 ; 16a, 16b) de non-excitation qui n'est pas excitée pour être mise en vibration, le résonateur piézoélectrique (10) excitant un harmonique du n-ième ordre (n est un nombre entier autre que 1) en mode longitudinal suivant l'épaisseur,
dans lequel, lorsque l'épaisseur du corps (12) d'élément est désignée par t et que l'épaisseur d'une couche unitaire est représentée approximativement par t/n, l'épaisseur de la couche (14 ; 14a, 14b) d'excitation doit être un multiple entier de l'épaisseur de couche unitaire et l'épaisseur de l'au moins une couche (16 ; 16a, 16b) de non-excitation doit être un multiple entier de l'épaisseur de couche unitaire,
dans lequel ladite au moins une couche (14 ; 14a ; 14b) d'excitation est formée adjacente à un plan principal extérieur dudit corps (12) d'élément sans couche de non-excitation entre la couche d'excitation et le plan principal extérieur.

2. Résonateur piézoélectrique (10) selon la revendication 1, dans lequel l'épaisseur de couche unitaire de la couche (14 ; 14a, 14b) d'excitation est dans la fourchette de 0,7 t/n à 1,2 t/n et l'épaisseur de couche unitaire de la couche (16 ; 16a, 16b) de non-excitation est dans la fourchette de 0,8 t/n à 1,3 t/n.

3. Résonateur piézoélectrique (10) selon l'une quelconque des revendications 1 et 2, dans lequel les électrodes (18, 20) de vibration sont formées seulement sur un plan principal de la couche (16) de non-excitation, ou dans lequel les électrodes (38, 40) de vibration étant au même potentiel sont formées sur les deux plans principaux de la couche (16) de non-excitation.

4. Résonateur piézoélectrique (10) selon l'une quelconque des revendications 1 à 3, dans lequel la couche (16 ; 16a, 16b) de non-excitation est faite de céramique piézoélectrique ou de céramique diélectrique, non polarisée.

5. Résonateur piézoélectrique (10) selon l'une quelconque des revendications 1 à 4, comprenant en outre :
une première et une seconde électrode (22, 24) de face d'extrémité formées sur la surface du corps (12) d'élément ;
une électrode (44 ; 44a) d'atténuation de réponse parasite connectée électriquement à la première électrode (22) de face d'extrémité,
dans lequel l'électrode (44) d'atténuation de réponse parasite est formée de façon à avoir un écartement constant (ESD) par rapport à une extrémité de l'électrode (20) de vibration connectée à la seconde face d'extrémité à l'autre extrémité dans une direction orthogonale à la direction de dépôt de la couche (14) d'excitation et de la couche (16) de non-excitation.

6. Résonateur piézoélectrique (10) selon la revendication 5, dans lequel le rapport entre l'écartement (ESD) et l'épaisseur (D) de couche unitaire, c'est-à-dire, écartement/épaisseur de couche unitaire, est dans la fourchette de 1,0 à 3,0.

7. Résonateur piézoélectrique (10) selon l'une quelconque des revendications 1 un 6, comprenant deux couches (14a, 14b) d'excitation formées adjacentes aux deux plans principaux extérieurs opposés dudit corps (12) d'élément sans couche de non-excitation entre la couche d'excitation respective et le plan principal extérieur.
